# EUROPEAN PATENT SPECIFICATION

(11) **EP 0 450 592 B1**
(45) Date of publication and mention of the grant of the patent: **13.08.1997**
(21) Application number: 91105244.7
(22) Date of filing: 03.04.1991
(51) Int. Cl.: G03F 9/00

(54) **Alignment system, particularly for X-ray or photolithography**
Ausrichtsystem, insbesondere für Röntgen- oder Photolithographie
Système d'alignement, particulièrement pour la lithographie aux rayons X ou la photolithographie

(30) Priority: 04.04.1990 DE 4010880
(43) Date of publication of application: 09.10.1991
(73) Proprietor: Karl Süss KG Präzisionsgeräte für Wissenschaft und Industrie - GmbH & Co., D-85748 Garching (DE)
(72) Inventor: Kaiser, Paul, W-8000 München (DE)
(74) Representative: VOSSIUS & PARTNER

(56) References cited:
- EP-A- 0 083 710
- EP-A- 0 091 234
- EP-A- 0 116 953

## Description

The invention relates to an alignment system, particularly for X-ray or photo lithography. This system is particularly useful in semiconductor technology.

In semiconductor technology very fine patterns or structures are transferred to wafers by chemical or physical etching with the help of masks for structuring the surface. By using X-ray lithography, particularly small structures can be obtained which lead to the desired high density of electronic or optical components on a wafer. X-ray lithography allows the resolution of structures in the sub-micrometer range. In this connection, the deviation in the mask/wafer alignment must be below 100 nm.

The US-A-4,595,295 discloses an alignment system for X-ray lithography wherein the mask and the wafer are each individually aligned with a reference mask. Said reference mask carries alignment marks which correspond to marks on the mask and on the wafer. The patterns or marks of the reference mask are transferred to the mask as well as to the wafer by light projection via a bright-field/dark-field microscope. When the light projected through the reference mask strikes the patterns on the mask and on the wafer, the scattered light leaving the pattern is either at a maximum or at a minimum, depending upon the pattern configuration. By detecting the intensity of the scattered light in a detector, a highly accurate relative alignment of the mask and the wafer can be achieved. The alignment system requires that the reference mask patterns be focused in two optical planes, namely in the mask plane and the wafer plane. To this end, optical means are provided at fixed distances between the microscope, the mask and the wafer; for instance a glass cube in the beam path of the reference mask. Due to said optical means, the reference mask patterns are simultaneously focused in the mask plane and the wafer plane. This construction has the following drawbacks: (1) The focus difference is determined by the thickness of the glass cube and is dependent on the wave length of the beam; (2) the passage of the beam through the glass impairs the image; (3) the manufacture of the glass cube is very complicated because the cube must contain bores for the non-modified beam path; and (4) the pattern image of the reference mask must exactly coincide with the actual widths of the structures on the mask and the wafer since otherwise an adjustment of the magnification is necessary.

A plane plate scanner is arranged within the microscope. Said scanner shifts the image of the reference mask patterns in a plane in directions perpendicular to each other (x-y-directions) so as to achieve an optimum alignment to the mask and wafer patterns. This construction has the following drawbacks: (1) The image forming beam path is influenced by the scan position; (2) the confined space within the microscope makes it difficult to house a scan drive; (3) the image distortions of a non-centered optical system reduce the usable scan range; and (4) an error in linearity occurs in the scan range.

The object underlying the present invention is to provide a device for aligning a mask and a wafer relative to one another via a reference mask by means of a bright-field/dark-field microscope, thereby eliminating the need for additional focussing means within the microscope.

This object is achieved by the features of the claims.

The invention is based on the finding that much space can be saved in the microscope and image distortions can be avoided if the focussing is not performed via optical means in the microscope but by a relative movement between the microscope with the reference mask and the device for detecting the light intensity (optical unit) on the one hand and the mask and the wafer on the other hand. The high accuracy required for this is achieved by suitable measures, preferably by using a piezo drive or comparable accurate drives.

The advantages of the present invention reside in a simpler and therefore less expensive manufacture of the aligning system, a more accurate alignment and a larger capture area or range for the mask and wafer patterns.

With the help of a piezo drive or a comparably accurate drive, the reference mask pattern can also be aligned to the mask and wafer patterns by a relative movement between the optical unit and the mask or the wafer. This relative movement can either be performed by a movement in the x and y direction in a plane parallel to the mask and wafer planes or by tilting about two axes that are perpendicular to each other. As a result, the drawbacks of arranging a scan means within the microscope can be avoided.

Suitable piezo drives are for instance known from EP-A-134 268.

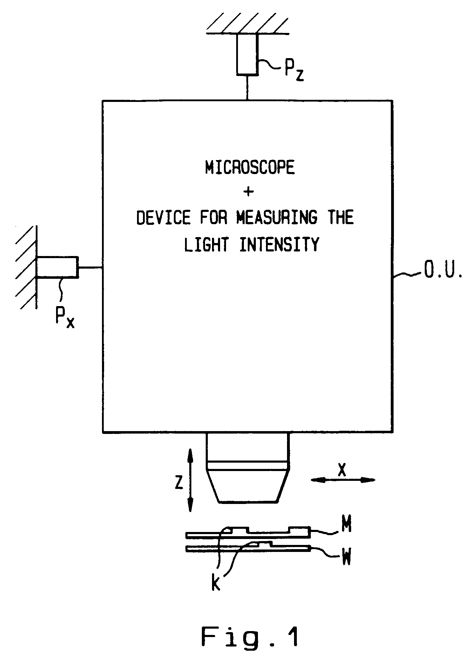

In the following, the invention is described in connection with a preferred but not limiting embodiment schematically shown in Fig. 1.

According to Fig. 1, the optical unit O.U. is shifted in x, y and z directions with respect to the mask and wafer structures. The optical unit O.U. is shifted in the z direction by means of a piezo drive P_{z} so that the reference mask patterns are subsequently focused on the mask M and on the wafer W. By shifting the microscope in the x and y directions (y direction perpendicular to the plane of the sheet of paper, not shown), an alignment of the reference mask patterns with respect to the corresponding patterns in the mask and wafer planes is performed with the piezo drives Pₓ and P_{y}. The used piezo drives are piezo-driven tables with a flexure bearing or a universal joint and having an amplitude of approximately 100 µm with a displacement resolution of 1 nm and a straight motion of 10 nm.

In another embodiment of the invention the optical unit O.U. is tilted about two axes that are perpendicular to each other after the focussing in the z direction with the piezo drive P_{z}. Said two axes lie in a plane parallel to the focal plane which is preferably 200 mm spaced apart from the focal plane in the direction of the optical unit O.U. The tilting movement is performed by one piezo drive in each case which works in the direction of the tilting and consequently shows a component in the x or y direction. As a result, an alignment of the patterns of the reference mask, the mask, and the wafer is obtained as in the case of parallel shifts in the x and y direction.

In addition to the use as alignment system for photolithography and X-ray lithography, the invention can be used for measuring the structural width of photosensitive resist layers. Test results with the system according to the invention were compared and coincided with measurements of a gauged scanning electron microscope in an error range of 50 nm.

## Claims

1. An alignment system, particularly for X-ray or photo lithography, comprising an optical unit (O.U.) with a dark-field/bright-field microscope and a device for detecting the light intensity, with a reference mask pattern being projected onto structures (K) of a mask (M) and a wafer (W), said structures lying in parallel planes, and the light scattered from the structures (K) being detected via the dark-field beam path, **characterized in that** the optical unit (O.U.) is mechanically movable with respect to the mask and wafer planes in order to move the focus of the optical unit (O.U.) between the mask plane and the wafer plane (z-direction).

2. The alignment system according to claim 1, **characterized in that** the mechanical movement is provided by means of a piezo drive (P_{z}).

3. The alignment system according to claim 1 or 2, **characterized in that** the optical unit (O.U.) as well as the mask (M) and the wafer (W) are movable relative to one another in parallel planes and in two directions that are perpendicular to each other (x-y directions) by means of piezo drives (Pₓ, P_{y}).

4. The alignment system according to claim 1 or 2, **characterized in that** the optical unit (O.U.) as well as the mask (M) and the wafer (W) are rotatable relative to one another about two axes that are perpendicular to each other and parallel to the mask and wafer planes by means of piezo drives.

5. The alignment system according to any of claims 2 to 4, **characterized in that** the piezo drive (P_{z}) for the Z-direction is a piezo-driven table with a flexure bearing or a universal joint.

6. The alignment system according to any of claims 1 to 5, **characterized in that** in case of the alignment in the z-direction the mask (M) and the wafer (W) remain stationary and the optical unit (O.U.) is moved or vice versa.

## Patentansprüche

1. Justiersystem, insbesondere für die Röntgen- oder Photolithographie mit einer Optik-Einheit (O.U.), bestehend aus einem Dunkelfeld/Hellfeld-Mikroskop und einer Einrichtung zum Detektieren von Lichtintensität, wobei ein Referenzmaskenmuster auf in parallelen Ebenen liegende Strukturen (K) einer Maske (M) und eines Wafer (W) projiziert und das Streulicht der Strukturen (K) über den Dunkelfeldstrahlengang detektiert wird, dadurch gekennzeichnet, daß die Optik-Einheit (O.U.) bezüglich der Masken- und der Waferebene mechanisch bewegbar ist, um den Fokus der Optik-Einheit (O.U.) zwischen der Maskenebene und der Waferebene (z-Richtung) zu bewegen.

2. Justiersystem nach Anspruch 1, dadurch gekennzeichnet, daß die mechanische Bewegung mittels eines Piezoantriebs (P_{z}) erfolgt.

3. Justiersystem nach Anspruch 1 oder 2, dadurch gekennzeichnet, daß die Optik-Einheit (O.U.) sowie die Maske (M) und der Wafer (W) mittels Piezoantrieben (Pₓ, P_{y}) in parallelen Ebenen und zwei zueinander senkrechten Richtungen (x-y-Richtungen) relativ zueinander bewegbar sind.

4. Justiersystem nach Anspruch 1 oder 2, dadurch gekennzeichnet, daß die Optik-Einheit (O.U.) sowie die Maske (M) und der Wafer (W) mittels Piezoantrieben um zwei zueinander senkrechte Achsen drehbar relativ zueinander und parallel zu den Masken- und Waferebenen bewegbar sind.

5. Justiersystem nach einem der Ansprüche 2 bis 4, dadurch gekennzeichnet, daß der Piezoantrieb (P_{z}) für die z-Richtung ein piezogetriebener Scharniergelenktisch ist.

6. Justiersystem nach einem der Ansprüche 1 bis 5, dadurch gekennzeichnet, daß bei Ausrichtung in z-Richtung die Maske (M) und der Wafer (W) stationär bleiben und die Optik-Einheit (O.U.) bewegt wird oder umgekehrt.

## Revendications

1. Système d'alignement, en particulier pour une lithographie aux rayons X ou une photolithographie, comprenant une unité optique (U.O.) avec un microscope champ sombre/champ clair et un dispositif pour détecter l'intensité lumineuse, avec un motif de masque de référence projeté sur des structures (K) d'un masque (M) et une plaquette (W), lesdites structures se trouvant dans des plans parallèles, et la lumière diffusée à partir des structures (K) étant détectées par l'intermédiaire du chemin de rayon en champ sombre, caractérisé en ce que l'unité optique (U.O.) est mécaniquement mobile par rapport aux plans du masque et de la plaquette afin de déplacer le foyer de l'unité optique (U.O.) entre le plan du masque et le plan de la plaquette (direction z).

2. Système d'alignement selon la revendication 1, caractérisé en ce que le mouvement mécanique est fourni au moyen d'un entraînement piézoélectrique (P_{z}).

3. Système d'alignement selon la revendication 1 ou 2, caractérisé en ce que l'unité optique (U.O.) de même que le masque (M) et la plaquette (W) sont mobiles les uns par rapport aux autres dans des plans parallèles et dans deux directions qui sont perpendiculaires l'une à l'autre (directions x-y) au moyen d'entraînements piézoélectriques (Pₓ, P_{y}).

4. Système d'alignement selon la revendication 1 ou 2, caractérisé en ce que l'unité optique (U.O.) de même que le masque (M) et la plaquette (W) peuvent tourner les uns par rapport aux autres autour de deux axes qui sont perpendiculaires l'un à l'autre et parallèles aux plans du masque et de la plaquette au moyen d'entraînements piézoélectriques.

5. Système d'alignement selon l'une quelconque des revendications 2 à 4, caractérisé en ce que l'entraînement piézoélectrique (P_{z}) pour la direction z est une table entraînée de manière piézoélectrique avec un palier de flexion ou un joint universel.

6. Système d'alignement selon l'une quelconque des revendications 1 à 5, caractérisé en ce que dans le cas de l'alignement dans la direction z, le masque (M) et la plaquette (W) restent fixes et l'unité optique (U.O.) est déplacée ou vice versa.
